Europäisches Patentamt

European Patent Office

Office européen des brevets

(11) Publication number: **0 472 274 A1**

# EUROPEAN PATENT APPLICATION

(21) Application number: **91305846.7**

(22) Date of filing: **27.06.91**

(51) Int. Cl.⁵: **G06F 13/40**

(30) Priority: **24.08.90 US 572742**

(43) Date of publication of application:
**26.02.92 Bulletin 92/09**

(84) Designated Contracting States:
**DE FR GB**

(71) Applicant: **International Business Machines Corporation**
**Old Orchard Road**
**Armonk, N.Y. 10504(US)**

(72) Inventor: **Curtis, Stephen Arthur**
**4421 Secluded Hollow**
**Austin, Texas 78727(US)**
Inventor: **Horne, Richard Louis**
**4573 Sunrise Boulevard**
**Delray Beach, Florida 33445(US)**
Inventor: **Huynh, Duy Ouoc**
**2600 Greenwood Terrace, G209**
**Boca Raton, Florida 33431(US)**
Inventor: **Kuhlmann, Charles Edward**
**383 NE 31 St.**
**Boca Raton, Florida 33431(US)**
Inventor: **Ogle, Scott Talmadge**
**17722 Briar Patch Trail**
**Boca Raton Florida 33487(US)**
Inventor: **Tran, Loc Tien**
**19107 Fairlawn Way**
**Boca Raton, Florida 33434(US)**

(74) Representative: **Blakemore, Frederick Norman**
**IBM United Kingdom Limited Intellectual**
**Property Department Hursley Park**
**Winchester Hampshire SO21 2JN(GB)**

(54) **Data processing apparatus having connectors to receive system components.**

(57) A planar board is provided with a bus means for interconnecting components of a data processing system adapted to operate with a central processing unit (CPU) of one type. A socket provided on the board is adapted to receive said one CPU and is also adapted to receive a CPU of a second type (and its special adapter) having one CPU. Bus modification means on the adapter and logic provided on the board (which responds to said bus modification means) permit the interconnected components of the data processing system to operate with the second CPU.

Rank Xerox (UK) Business Services

FIG. 3

32 — 80386 or 80386 SX  
39 — math coprocessor

34 cpu local bus

35 — bus control timing

hold req/ack  address  data  control

68  latch / buffer  decoder

planar I/O bus 69

control data  address

84 intr cnlr  
76 rs232 adapter

10

50  48  dma contrlr

49  central arbiter

51  arb. bus  buffer

54 — I/O slot

54 — I/O slot

70 — display adapter

57  56  diskette adapter

cmos ram

72  cmos clock

parallel adapter

timer

ROM

74  78  80  64

ROMSEL

memory 36 controller

ras, cas, we

control (ras, cas decode) — 59  
address mux — 60  
data buffer — 61

Micro Channel bus 52

38 dram sip  basic 1MB  
65 dram sip  optional 2MB  
66 dram sip  optional 2MB  
67 dram sip  optional 2MB

memory data

This invention relates to data processing apparatus having a system planar board having connectors to receive system components and a bus structure for interconnecting the components.

In prior art personal computers systems, each microprocessor chip type has led system developers to design a separate system and architecture for that chip. The current practice of the industry is to design separate system boards (also known as planars) for each platform since they carry different logical/physical interfaces and require different supporting logics.

One example of this industry practice is seen in the development of personal computer systems by INTERNATIONAL BUSINESS MACHINES CORPORATION. The IBM PS/2 systems models 8570 and 8580 were designed using Intel 80386 microprocessors. On the other hand, low-cost, high-volume systems such as the IBM PS/2 model 55 were based on the Intel 80386SX microprocessor because of the substantial cost difference between the 2 microprocessors. IBM and IBM PS/2 are trademarks of INTERNATIONAL BUSINESS MACHINES CORPORATION; Intel is a trademark of Intel Corporation.

The cost difference between the two microprocessors is due in part, if not primarily to the substantially greater power dissipation required for the 80386 leading to a ceramic pin grid array package. The 80386SX its with lower power dissipation requirements uses a less expensive plastic flat pack package.

However, the two microprocessors have substantial similarities with most of the control input/outputs being the same. The primary functional differences are the provision of different data output bus widths and different address output bus widths as will be seen below. Yet the industry typically expends the high development costs and additional costs of having to fabricate and stock components for two separate systems.

According to the present invention there is provided data processing apparatus comprising a system planar board having connectors adapted to receive system components and having a bus structure for interconnecting said components for the performance of data processing functions under program control characterised in that there is provided a socket on the board adapted to receive a processor which may be of a first or a second type, the two types having dissimilar processor buses, program controlled logic on the board effective when a processor of the first type is mounted in the socket for effecting data processing functions with system components connected to the bus structure and, additional logic on the board for modifying the operation of the program controlled logic when a second processor of the second type is mounted in the socket.

Further according to the present invention there is provided a data processing system in which a system planar board has a socket adapted to receive a first central processing unit having a processor bus of a first type, connectors adapted to receive system components and a board bus structure appropriate to the processor bus of the first type for interconnecting the processor bus with the system components to enable the execution of processing functions under program control, a processor mounting structure for coupling a second processor, having a bus structure of a second type differing from that of the first, to the board bus structure and system components for the execution of processing functions under program control, said processor mounting structure comprising an adapter having a pluggable structure received in said socket, electrical bus modification structure in the adapter for modifying the board bus structure to cooperate with a processor bus structure of the second type.

Thus the present invention proposes to eliminate the added costs and inefficiencies of two separate systems for microprocessors which have substantial similarity by providing a system design which is adapted to operate with either one of the two processors coupled into the system.

The improved system design uses a dual-platform which advantageously accommodates both microprocessors by means of a unique socket and adaptor arrangement together with a single system board having logic and physical changes to operate properly with either processor.

In a preferred embodiment of the present improvement, shown merely by way of example, a logic and physical design allows an INTEL 80386SX 16 bit processor to operate in a system designed for an INTEL 80386 32 bit processor. In a preferred embodiment, the logic is implemented on a cost reduced planar board for the IBM 8570 system. This planar board uses two gate arrays for main memory and bus control. The unique logic functions are implemented internal and external to these gate arrays together with a unique socket, adapter design which can accommodate either INTEL processor on one planar layout.

The improved 8570 planar design supports either an INTEL 80386 or 80386SX processor as the main CPU. There are four main functional areas which must be modified to accommodate both processors. They are the processor to system interface, the data routing logic, the data byte enable function and the address bus decode logic.

Except for the above changes, the system of the preferred embodiment is substantially identical to the widely known and used IBM 8570. This system and its details are described in the IBM Personal System/2, Model 70, Technical Reference Manual, First Edition (May, 1988) and in other manuals referred to therein.

Personal System/2 is a trademark of INTERNATIONAL BUSINESS MACHINES CORPORATION.

In the drawings:

Figure 1 is a perspective view of a personal computer embodying the present invention.

Figure 2 is an exploded view of certain elements of the personal computer of Figure 1.

Figure 3 is a block diagram of the preferred embodiment of the improved system.

Figures 4A and 4B respectively illustrate plan and elevation views of the 132 pin grid array (PGA) package of the 80386.

Figures 5A and 5B respectively illustrate plan and elevation views of the 100 pin quad-flat-pack (QFP) package of the 80386SX, a first substrate on which the QFP is mounted and a second substrate with a 160 pin grid array to which the first substrate is physically and electrically coupled to form a pin grid array adapter.

Figure 5C is a fragmentary elevation view of a socket adapted to receive the PGA of Figure 4B or the adaptor of Figure 5B and of the planar board upon which system components are mounted.

Figure 5D is a plan view of a 160 PGA socket for receiving the adapter of Figures 5A, 5B.

Figure 6 is a fragmentary block diagram illustrating certain logic changes required by the improved system.

Figure 7 illustrates diagrammatically circuit connection changes to the 8570 system required to accommodate the 80386SX microprocessor.

Figures 8-12 inclusive are schematical diagrams of control logic required to accommodate the 16 or 32 bit CPU bus.

Figure 13 shows the data steering logic in table form for a system having an IBM Micro Channel and an INTEL processor such as an 80386 or an 80386SX.

Detailed Description of Invention

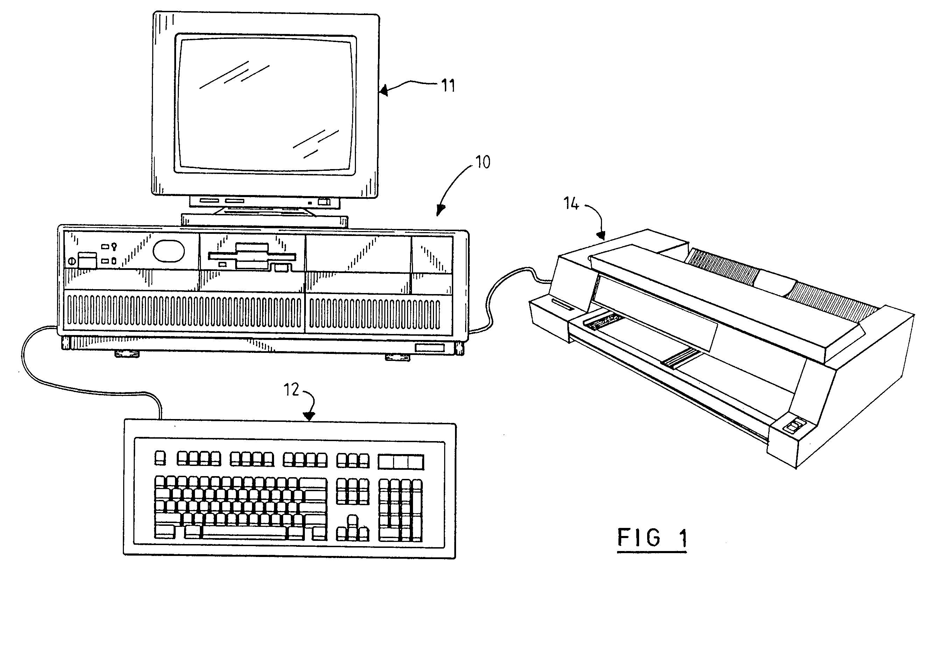

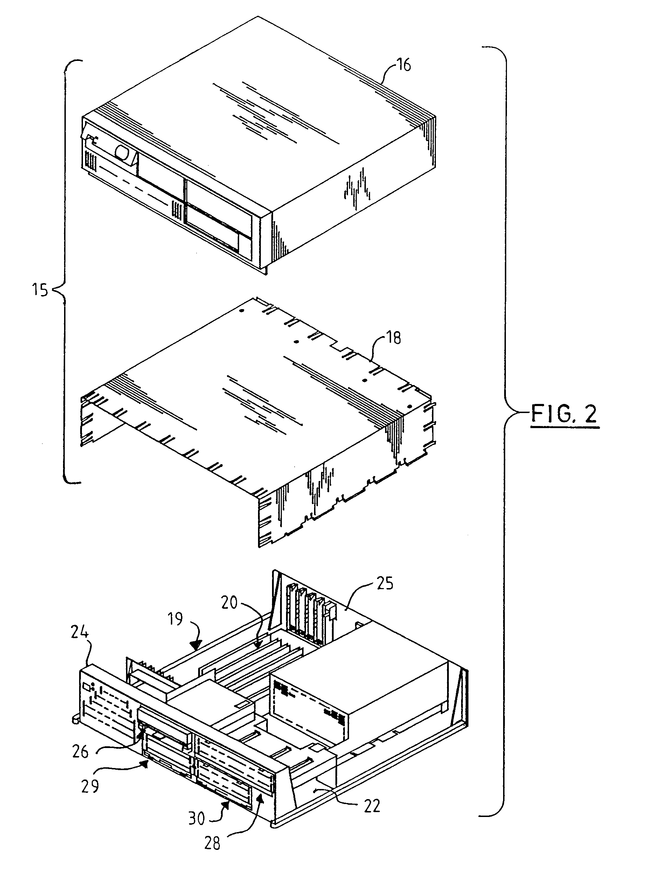

Referring now more particularly to the accompanying drawings, a microcomputer embodying the present invention is shown and generally indicated at 10 (Figure 1). As mentioned hereinabove, the computer 10 may have an associated monitor 11, keyboard 12 and printer or plotter 14. The computer 10 has a cover 15 formed by a decorative outer member 16 (Figure 2) and inner shield member 18 which cooperate with a chassis 19 in defining an enclosed, shielded volume for receiving electrically powered data processing and storage components for processing and storing digital data. At least certain of these components are mounted on a planar 20 which is mounted on the chassis 19 and provides a means for electrically interconnecting the components of the computer 10 including those identified above and such other associated elements as floppy disk drives, various forms of direct access storage devices, accessory cards or boards, and the like.

The chassis 19 has a base indicated at 22, a front panel indicated at 24, and a rear panel indicated at 25 (Figure 2). The front panel 24 defines at least one open bay (and in the form illustrated, four bays) for receiving a data storage device such as a disk drive for magnetic or optical disks, a tape backup drive, or the like. In the illustrated form, a pair of upper bays 26, 28 and a pair of lower bays 29, 30 are provided. One of the upper bays 26 is adapted to receive peripheral drives of a first size (such as those known as 3.5 inch drives) while the other bay 28 is adapted to receive drives of a selected one of two sizes (such as 3.5 and 5.25 inch) and the lower bays are adapted to receive devices of only one size (3.5 inch).

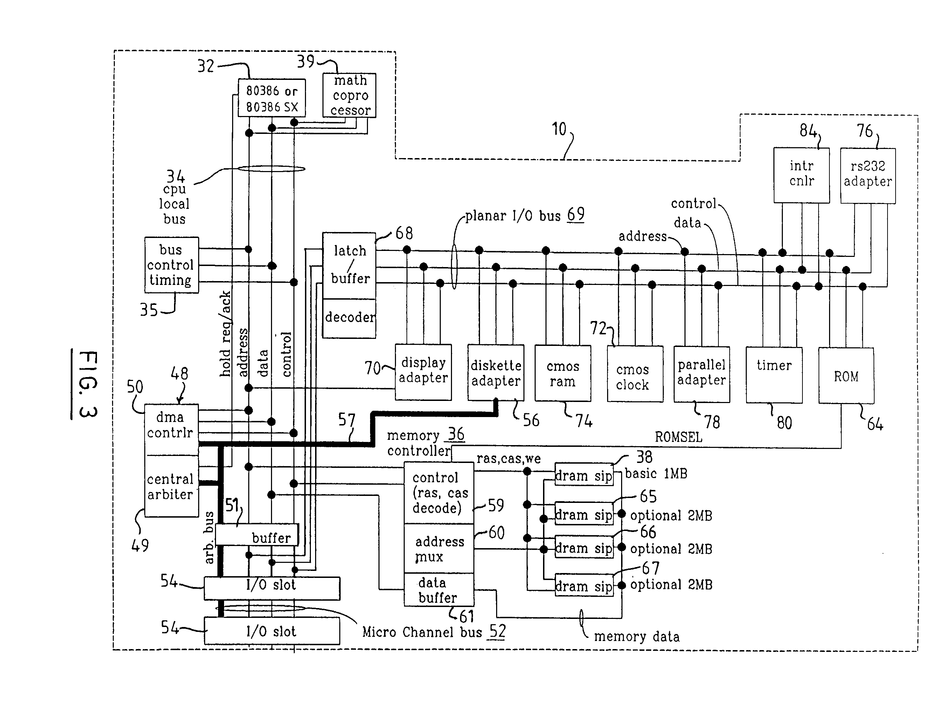

Prior to relating the above structure to the present invention, a summary of the operation in general of the personal computer system 10 may merit review. Referring to Figure 3, there is shown a block diagram of a personal computer system illustrating the various components of the computer system such as the system 10 in accordance with the present invention, including components mounted on the planar 20 and the connection of the planar to the I/O slots and other hardware of the personal computer system. Connected to the planar is the system processor 32 comprised of a microprocessor which is connected by a high speed CPU local bus 34 through a bus control timing unit 35 which is further connected to a volatile random access memory (RAM) 38.

While the present invention is described hereinafter with particular reference to the system block diagram of Figure 3, it is to be understood at the outset of the description which follows that it is contemplated that the apparatus and methods in accordance with the present invention may be used with other hardware configurations.

Returning now to Figure 3, the CPU local bus 34 (comprising data, address and control components 34D, 34A, 34C) provides for the connection of the microprocessor 32 and a math coprocessor 39. Also coupled on the CPU local bus 34 is a buffer 51. The buffer 51 is itself connected to a Micro Channel bus 52, also comprising address, data and control components. The bus 34 is further connected to a DMA unit

4

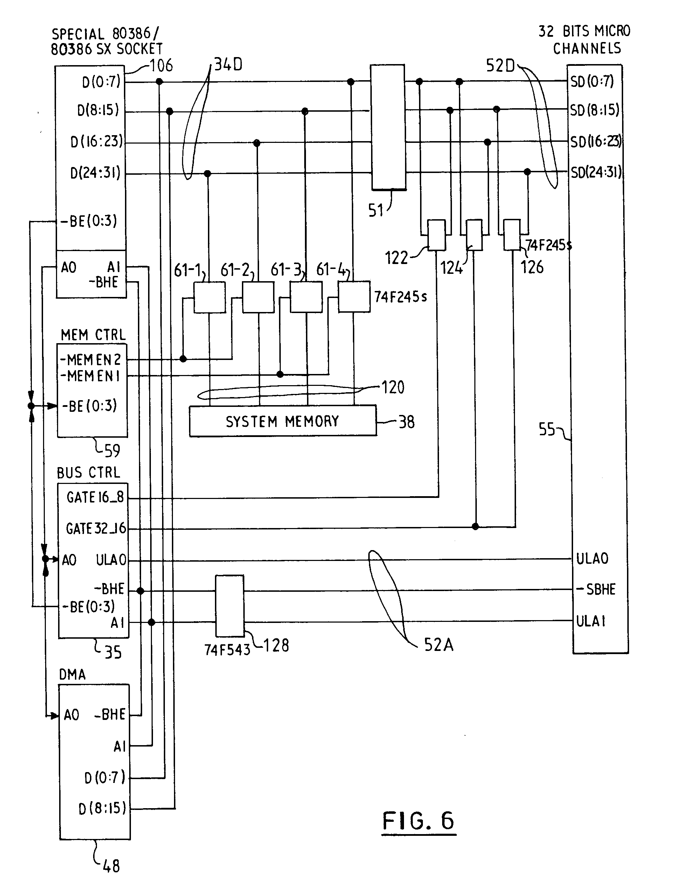

48 comprised of a central arbitration unit 49 and DMA controller 50. The buffer 51 provides an interface between the local bus 34 and an optional feature bus such as the MICRO CHANNEL bus 52. Connected to the bus 52 are plurality of I/O slots 54 for receiving MICRO CHANNEL adapter cards 55 (Figure 6) each of which may be further connected to an I/O device or memory.

An arbitration control bus 57 couples the DMA controller 50 and central arbitration unit 49 to the I/O slots 54 and a diskette adapter 56. Also connected to the local bus 34 is a memory control unit 36 which is comprised of a memory controller 59, an address multiplexor 60, and a data buffer 61. The memory control unit 36 is further connected to a random access memory as represented by the RAM module 38. The memory controller 36 includes the logic for mapping addresses to and from the microprocessor 32 to particular areas or RAM 38. This logic is used to reclaim RAM previously occupied by Basic Input Output System (BIOS). Further generated by memory controller 36 is a ROM select signal (ROMSEL), that is used to enable or disable ROM 64.

While the microcomputer system 10 is shown with a basic 1MB (megabyte) RAM module 38, it is understood that additional memory can be interconnected as represented in Figure 3 by the optional memory modules 65 through 67. For purposes of illustration only, the present invention is described with reference to the basic one megabyte memory module 38.

A further buffer 68 is coupled between the bus 52 and a planar I/O bus 69. The planar I/O bus 69 includes address, data, and control components respectively. Coupled along the planar bus 69 are a variety of I/O adapters and other components such as the display adapter 70 (which is used to drive the monitor 11), a clock 72, nonvolatile RAM 74, herein after referred to as NVRAM, a RS232 adapter 76, a parallel adapter 78, a plurality of timers 80, a diskette adapter 56, an interrupt controller 84, and a read only memory 64. The read only memory 64 includes the Basic Input/Output System (BIOS) that is used to interface between the I/O devices and the operating system of the microprocessor 32. BIOS stored in ROM 64 can be copied into RAM 38 to decrease the execution time of BIOS. ROM 64 is enabled by memory controller 36. BIOS is executed out of ROM. If ROM 64 is disabled by memory controller 36, ROM is not responsive to address enquiries from the microprocessor 32 (i.e. BIOS is executed out of RAM).

The clock 72 is used for time of day calculations and the NVRAM is used to store system configuration data. That is, the NVRAM will contain values which describe the present configuration of the system. For example, NVRAM contains information describing the capacity of a fixed disk or diskette, the type of display, the amount of memory, time, date, etc. Of particular importance NVRAM will contain data (can be one bit) which is used by memory controller 36 to determine whether BIOS is run out of ROM or RAM and whether to reclaim RAM intended to be used by BIOS RAM. Furthermore, these data are stored in NVRAM whenever a special configuration program, such as SET Configuration, is executed. The purpose of the SET Configuration program is to store values characterising the configuration of the system to NVRAM.

## Processor to System Interface

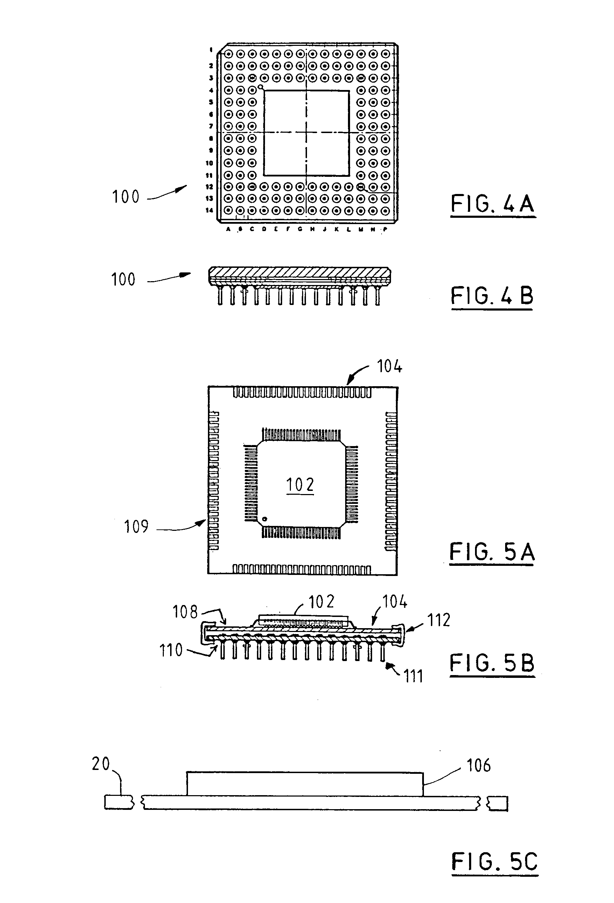

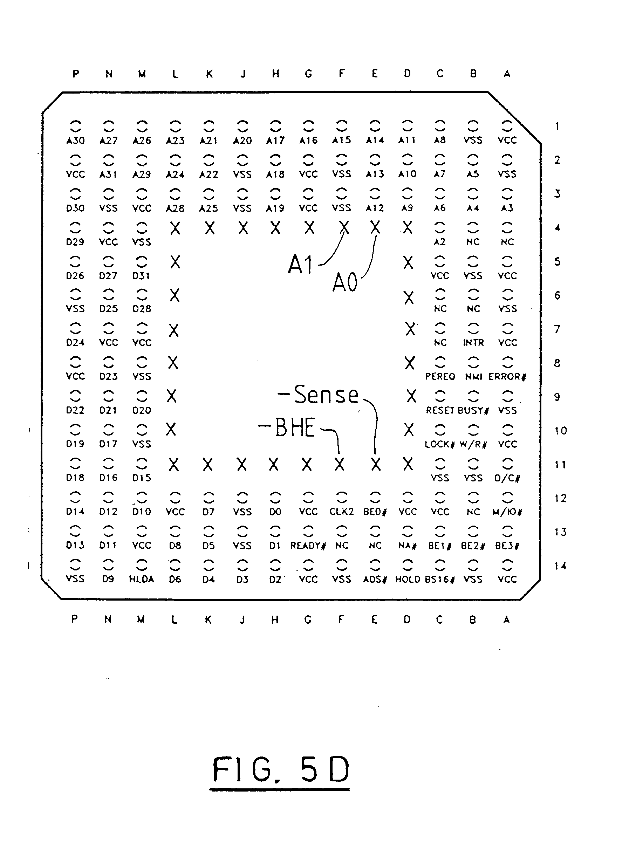

Attention is directed to Figures 4A, 4B, which show a conventional INTEL 80386 in its pin grid array (PGA) package 100 of 132 pins, and to Figures 5A-5D which show an INTEL 80386SX processor in its Quad Flat Pack (QFP) package 102, an adapter 104 for configuring the QFP package to a PGA package and a modified 160 PGA socket 106 on the system planar board 20 which is adapted to receive either the 80386 package of Figure 4B or the modified 80386SX package of Figure 5B. Figure 5D shows, in the outer three peripheral rows and columns of socket 106, the conventional pin connections for an 80386 processor PGA package. The inner rows and columns of "X"s represent pin connections which have been added to the socket 106 to accommodate pins from the 80386SX which do not exist for the 80386.

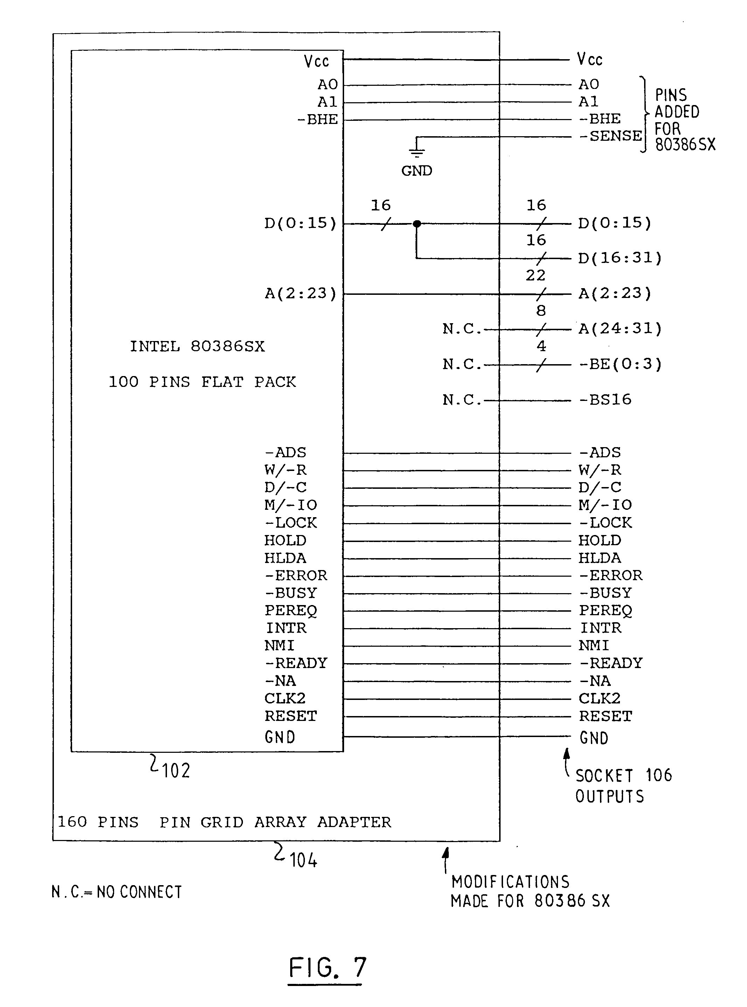

The physical differences between the 80386 and the 80386SX processors affect both layout and function. The 80386 comes in a 132 pin pin-Grid-Array (PGA) package and the 80386SX is packaged as a 100 pin Quad-Flat-Pack (QFP). While the 80386 uses four byte enable (BE0 to BE3) lines (Figures 6,7), a 30 bit address bus A2-A31 and a 32 bit data bus D0-D31, the 80386SX uses a byte high enable (+BHE) line, a 24 bit address bus A0-A23 and a 16 bit data bus D0-D15. A 160 pin socket 106 is used to accommodate the 80386 pinout plus the A0, A1 and +BHE signals unique to the 80386SX. The adapter scheme must be used with the 80386SX to convert the layout from QFP to PGA, to physically connect the 16 bit data bus to both halves of the 32 bit data bus, to pass the three unique signals A0, A1, +BHE, and to provide an additional -SENSE signal to indicate when the 80386SX is installed.

## Socket Adapter 104

The adapter solution proposed in the preferred embodiment, Figure 5A, 5B, uses the existing 80386

EP 0 472 274 A1

module and footprint as is, and mounts the 80386SX QFP 102 on a unique carrier 104 that matches the pinout footprint and the general physical dimensions of the 80386. Two substrates are used in the unique socket adapter. The 80386SX is soldered to a substrate 108. Wiring on this substrate fans out to pads 109 on the perimeter of the substrate. Any required wiring, such as shorting data lines together, may be routed on this substrate. Pins 111 are attached to a substrate 110 in the same physical pattern as the 80386 module. Wiring on this substrate 110 connects the pins to perimeter pads that match up to the pads on substrate 108. The two substrates are attached together by aligning the perimeter pads on each substrate and soldering.

The preferred substrate material is a fire retardant epoxy - glass cloth laminate, FR-4. for cost reasons, though other materials may be used. The preferred pin attachment to substrate 110 is by swaging and soldering. Edge clips 112 may be used to attach and solder the two substrates together.

Two substrates are used for this implementation because the pin footprint of the 80386SX QFP interferes with the pin locations of the 80386. To accomplish the same idea on only one substrate would require a multilayer substrate with blind via technology and brazed pin attachment. Multilayer ceramic (MLC) technology fits this description, but the cost of an MLC version of this module would be about 10 times the cost of the proposed two substrate version.

Data Routing Logic

Figure 6 is a fragmentary block diagram illustrating portions of the system of Figure 3 which are modified in the IBM 8570 system for controlling the routing of data between the local processor 32 (80386 or 80386SX), the main memory 38, the DMA 48, and Micro Channel devices such as 55, which are connected to respective I/O slots 54, via local bus 34D, Micro Channel bus 52D and buffer 51.

Thus Figure 6 illustrates the socket 106 with only certain of the pin connections, i.e. the data buses 34D for four bytes of data D0-D7, D8-D15, D16-D23, D24-D31. It also includes the byte/word addressing bits BE0-3 for an 80386 and the byte/word addressing bits A0, A1 and -BHE for an 80386SX. It will be noted (Figure 7) that the 80386 uses only address bits A2-A31 (not A0, A1) whereas the 80386SX uses address bits A0-A23.

Figure 7 shows the 80386SX processor package 102 mounted on its adapter 104, the outputs of socket 106 which are connected to corresponding data, address, control and power supply inputs to the system planar board 20. The modifications to the standard 80386 socket outputs are shown diagrammatically on the adapter 104.

The outputs A24-31, -BE 0-3, -BS16 (which are effective when an 80386 is connected) are left uncoupled (NC) when an 80386SX is connected. The upper data lines D16-31 are physically connected to the lower data lines D0-D15, that is D16 to D0, D17 to D1... and D31 to D15. New address lines A0, A1, -BHE are provided when the 80386SX is connected to the socket 106 via adapter 104 and a new line -SENSE for the 80386SX is grounded on the adapter 104.

Returning to Figure 6, the 80386 outputs -BE 0-3 are coupled to the memory controller 59 to selectively couple the four bytes of the memory bus 120 to respective bytes of the local bus 34D, outputs -BE0-3 are also coupled to the bus control logic 35 to produce appropriate output signals on the ULA0, A1 and -BHE.

The 80386SX outputs A1 and -BHE are applied to the bus control logic 35 and to A1 and -BHE of the DMA. The 80386SX output A0 and the DMA output A0 are applied to the bus control logic 35. Outputs gate 16-8 and gate 32-16 of logic 35 respectively control the transfer of data between lines SD0-7 and SD8-15 and between lines SD0-15 and SD16-31 of bus 52D by means of bi-directional gates 122, 124 and 126. Address line ULA0 is coupled directly between logic 35 and Micro Channel Devices such as 55 whereas lines -BHE, A1 of logic 35 are coupled to lines -SBHE and ULA1 by means of a buffer 128.

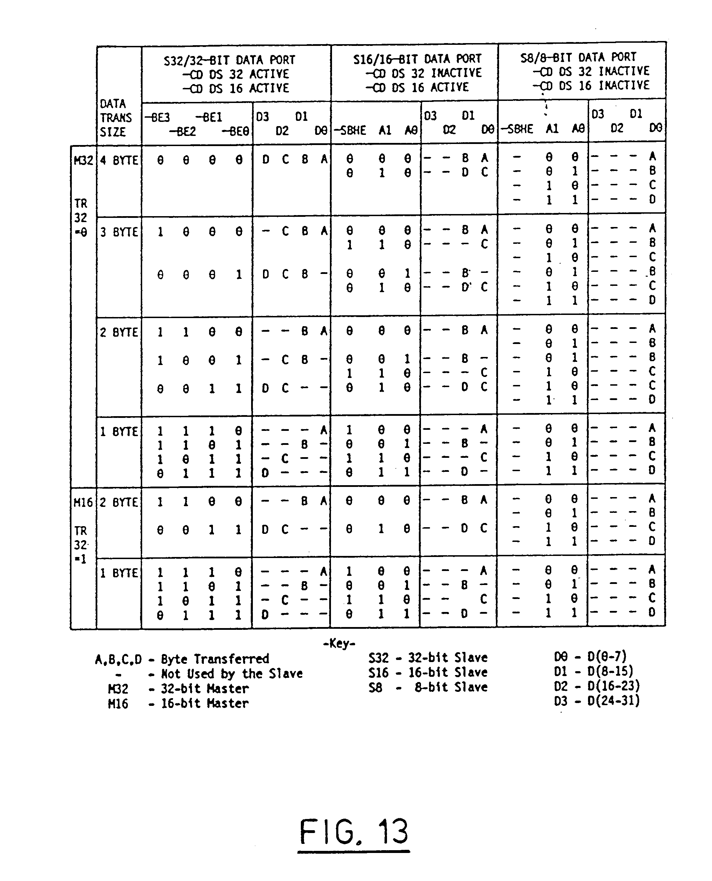

During data transfer procedures, data can be transferred between a 16-bit or 32-bit master, and an 8-bit, 16-bit or 32-bit slave. The table of Figure 13 shows the relationship between the data bus, associated signals, and the number of cycles required for the combinations of data transfer and steering.

The system random access memory (RAM) 38 local to the 8570 system is organised 32 bits wide and so looks like a 32 bit memory slave device to the 80386 local processor 32 and to a Micro Channel Bus Master device such as 55. The 80386SX processor has only a 16 bit data bus. One of the required features of the 80386SX socket adapter is to physically connect the high and low order halves of the 32 bit processor local data bus, 34D.

The system memory bus 120 is driven onto the processor local data bus 34D by four byte-wide buffers 61-1 to 61-4 (of buffer 61) (Figure 6). An instruction fetch or 32 bit data read by the 80386 processor drives byte enable logic to the memory control 59 which then fetches four bytes from RAM 38 and drives all four data buffers onto the processor bus simultaneously. Unlike the 80386, the 80386SX does not drive byte

6

enable signals (BE) directly but instead drives address lines A0, A1 and bus control signal called Bus High Enable (-BHE). Since the 80386SX requires two bus cycles to fetch a 32 bit instruction, the A1 signal indicates which 16 bit half of the data must be driven onto the bus. These three signals A0, A1, and -BHE are connected to three of the inside pins of the socket adapter 106 (Figure 5D) and so are only driven by the processor when an 80386SX is installed.

The two low order address bits A0, A1 and byte high enable signal -BHE from the 80386SX are physically connected on the local bus with the corresponding DMA signals DMA A0, DMA A1 and -DMA BHE (Figure 6). This enables both devices, the DMA 48 and the 80386SX to share the same bus and communicate with each other without having to go through additional delays. The Bus Control 35 contains logic which drives the appropriate BE signals to the Memory Control 59 depending on the state of A0, A1 and -BHE. Only two byte enables can be active at one time for the 80386SX to read or write either memory data bits 0-15 or 16-31 onto the bus. Again, since both halves of the data bus are physically connected on the 80386SX socket adapter, the data is always routed to the processor correctly and there is no bus contention because the memory system only drives one half at a time.

Other Micro Channel data routing logic must be modified in the Bus Control Logic 35 in the following manner: First, output enables that allow data to be driven to and from D16-D31 of the local bus and SD16-SD31 of the Micro Channel bus must be disabled if the CPU is the 80386SX. This is because the high and low order 16 bits of the local data bus are connected when the 80386SX socket adapter is installed. Second, when the 16 bit DMA 48 is controlling the bus in an 80386 (32-bit) system, odd word read of devices on the local data bus have to be routed out SD16-SD31 of the Micro Channel bus 52D, crossed over to SD0-SD15, and routed back into D0-D15 of the Local bus and then into the DMA. In an 80386SX system it is not necessary to route this data to the Micro Channel and back to the Local bus. The data will always be available directly to the DMA controller on D0-D15 of bus 34D.

The 80386 generates -BE0-3 and A2-31. The 80386SX provides -BHE, along with A0-23. Similarly the DMA chip 48 (which is both a master and slave device) drives a DMA -BHE and DMA A0-23 in both directions. The bus control logic 35 must interface the aforementioned three devices (processor, DMA, memory) to the Micro Channel bus 52 which drives -SBHE and ULA0-31.

The DMA 48 and the 80386SX low order addresses and byte enable addresses (A0/DMA A0, A1/DMA A1, -BHE/DMA -BHE) are physically connected together on the local bus of the system. This enables both devices to share the same bus consisting of the aforementioned signals, thus minimising the number of traces on the planar board. It also permits them to talk directly to each other without going through addition delays.

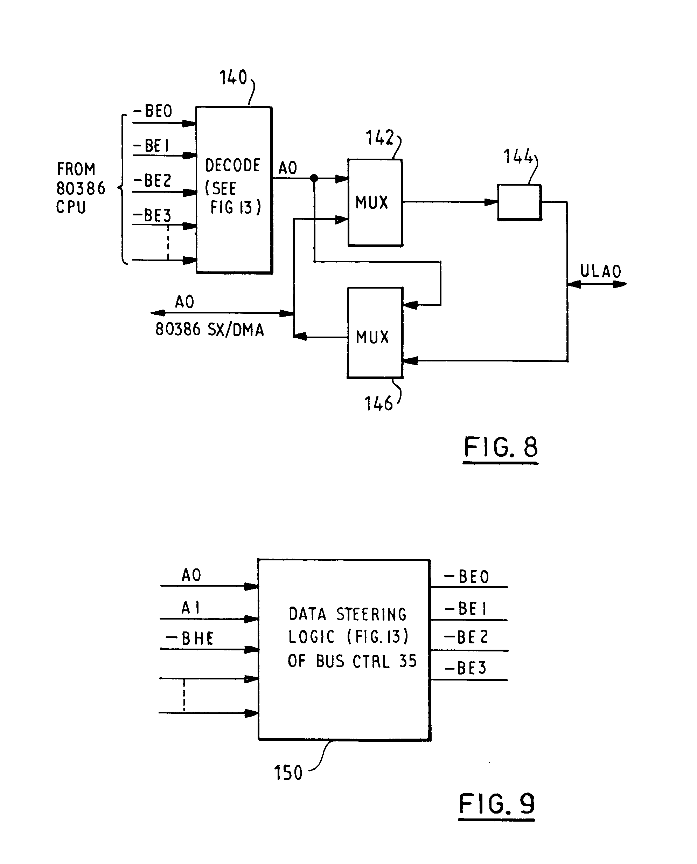

Only A1/DMA A1 and -BHE/DMA -BHE are driven directly to the Micro Channel system bus 52A through buffer 128. A0/DMA A0 is rerouted through the logic 35 before being injected into the channel. This is because another source of A0 is provided from the 80386. This source of A0 is obtained by decoding the signals -BE0-3 from the 80386 in a decoder 140 (Figure 8) of logic 35. The 80386 A0 and DMA/80386SX A0 must be multiplexed together to obtain the appropriate signal on line ULA0. Also the resulting internally formed A0 is modified by conversion logic 144 in the event that a conversion cycle occurs, i.e. an 8-bit data transfer to a 16-bit slave device occurs and more than one cycle is required.

When either the 80386 or a 16-bit or 32-bit channel device such as 55 is the master, the logic of Figure 8 multiplexes the two A0 sources. For an 80386, A0 is decoded from the signals -BE0-3 of the 80386. For a 16 or 32 bit master, A0 is driven directly from ULA0. The result is presented to the DMA 48.

With particular reference to Figure 8 this logic which forms a part of the bus control logic 35 includes decode logic 140 which is responsive to the signals -BE0-3 from an 80386 to produce an output A0 in accordance with the logic illustrated in Figure 13. For example, -BE0 = 0 always produces an output A0 = 0, whereas -BE0 = 1 produces A0 = 1 or 0 for various transfer conditions as shown in Figure 13 which will be described in more detail below.

Both the 80386 A0 the DMA/80386SX A0 are applied to a multiplexer 142 to produce an output on line ULA0 to the devices such as 55 via conversion logic 144. Devices such as 55 drive signals to the DMA A0 via multiplexer 146 and the 80386 A0 is applied to the DMA A0 via the multiplexer 146 during DMA initialisation data transfers when the 80386 is coupled to the board 20.

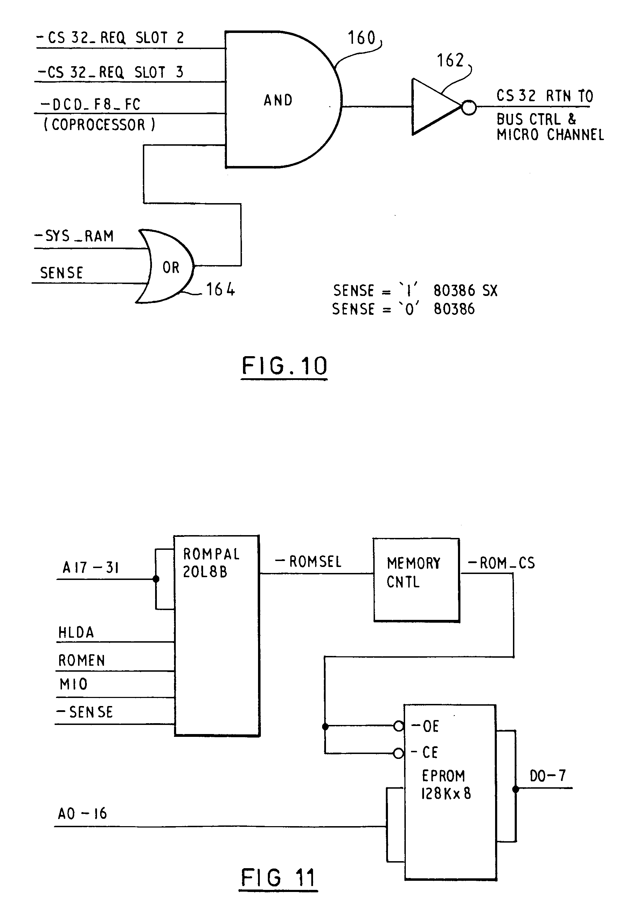

The logic 150 (Figure 9) which forms a part of the bus control logic 35 diagrammatically illustrates the manner in which output signals A0, A1 and -BHE from a connected 80386SX are decoded to produce outputs -BE0-3 which is used in the memory control logic 59 to produce -MEM.EN1 and -MEM.EN2 for enabling the buffers 61-1 to 61-4 to selectively couple the memory bus 120 to the physically coupled upper and lower halves of the local data bus 34D. The translation from A0, A1 and BHE to -BE0-3 is shown in Figure 13. Briefly, the signal level on line A1 determines which of the upper or lower two bytes will be transferred during a given memory cycle. When A1 = 0 the lower two bytes of memory are transferred between the local data bus and memory; and when A1 = 1 the upper two bytes are transferred between the memory and the local data bus. The signal levels on lines A0 and -BHE determine which of the two bytes will be transferred during any given memory cycle. For example, when A0 = 0 and -BHE = 0 both bytes will be transferred. When A0 = 0 and -BHE = 1 the lower byte will be transferred. When A0 = 1 and -BHE = 0 the upper byte will be transferred.

It will be recalled that changes to the IBM 8570 are required in order to adapt the 32-bit Micro Channel interface to a 16-bit system processor. Logic is included to modify local byte enable signals when a 32-bit Micro Channel bus master is accessing planar RAM on the processors local data bus 34D. The data routing logic is modified so that output enables, that allow data to be driven from D16-D31 of the processor data bus to SD16-SD31 of the Micro Channel data bus and from SD16-SD31 to D16-D31, are disabled if the CPU 32 is a 16-bit 80386SX. This is due to the fact that the D16-D31 and D0-D15 are physically connected when the 80386SX processor and its adapter are used. When the 16-bit DMA 48 is controlling the bus 34D in an 80386 system, odd word reads of devices on the local data bus 34D are routed out to SD16-SD31 of the Micro Channel bus 52D, crossed over to SD0-SD15 by means of gates 124 and 126 of Figure 6, and routed back into D0-D15 of the local bus 34D and then into the DMA 48. In an 80386SX 16-Bit system, this data is not routed out to the Micro Channel data bus and back to the local because it is already directly available to the DMA 48 on lines D0-15 which have been already connected to the lines D16-D31. These logical changes to the bus control 35 allow the planar board 20 to support either the 32 bit 80386 or the 16-bit 80386SX. Some of these changes will now be described in more detail.

## Micro Channel Control

In the IBM 8570 System, the data path from local system memory 38 to the Micro Channel Slots 54 is through three buses, the Memory bus 120, Local bus 34D, and System bus 52D. There is a control signal on the Micro Channel labelled CS32 RTN (Figure 10) which when active high indicates to a Bus Master such as 55 that the slave memory device just accessed is capable of driving a 32 bit wide data bus. This output signal is a negative OR of the CS32 signals from each channel connector such as those shown as inputs to the AND, invert circuits 160, 162. For example the inputs -cs32 for slots 2 and 3 and the corresponding input for a coprocessor dcd f8 fc are show as inputs to the AND circuit 160. In the normal 8570 system, -sys ram input is also applied to the AND circuit 160. If any device drives its cs32 signal active then this output CS32 RTN is active. This signal is provided to allow controlling masters to monitor data size information. The -cs32 lines as indicated above are driven by 32 bit slave devices to provide an indication on the bus of the 32 bit data port at the location addressed. Each signal is unique to a channel connector position and is derived from a valid address decode. All 32 bit slaves must drive this signal and it is inactive for 8 or 16 bit data ports.

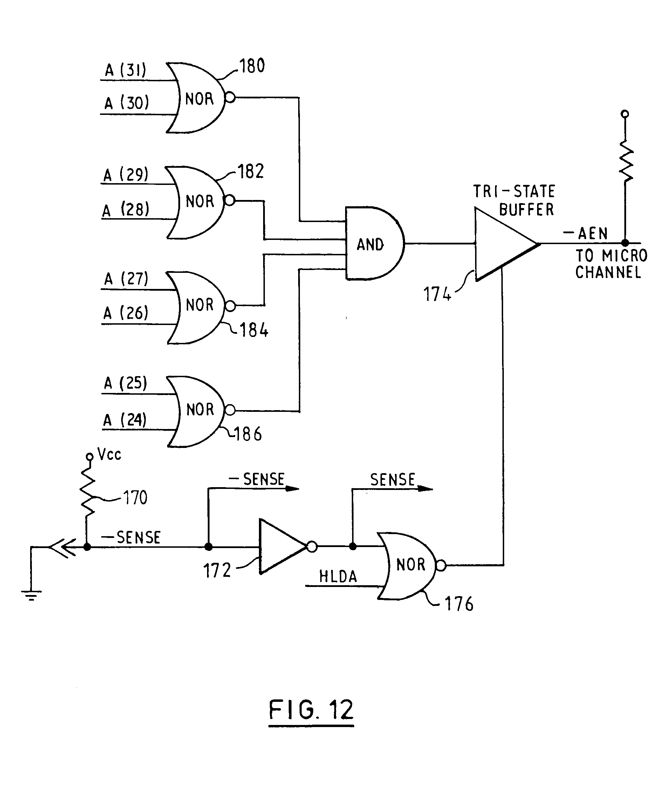

When an 80386 processor is plugged into the system board 20 the local system memory looks like a 32 bit memory slave and therefore CS32 RTN is driven active whenever it is accessed by a bus master on the channel. The local system memory is effectively 16 bit wide when an 80386SX is plugged into the system because the high and lower order halves of the local data bus 34D are wired together. Consequently CS32 RTN must be blocked (kept inactive) to the channel for all local memory cycles when the 80386SX is installed so that memory looks like a 16 bit slave. This logic function is enabled by the -SENSE signal shown in Figure 10 which originates (as illustrated in both Figures 7 and 12) from the adaptor 104 associated with the 80386SX.

## Sense Signal

The -SENSE signal as illustrated in Figure 12 is pulled to a positive level by a resistor 170. It is driven from a pin connected to the processor socket 106 and adapter 104 (Figure 7). When the 80386 is installed in the socket the -SENSE signal is left unconnected and therefore floats at the positive voltage. When the 80386SX is mounted on its special adapter 104 and installed in the socket 106 the appropriate adapter pin contacts the -SENSE pin on the 160 pin socket and ties the signal -SENSE to ground. The -SENSE signal is inverted by inverter 172 and applied to a tri-state buffer 174 by way of a NOR circuit 176. The inverted output SENSE is also coupled to the OR circuit 164 of Figure 10 when this SENSE line is at a logical 1 level indicating the connection of an 80386SX the signal CS32 RTN is blocked. When this SENSE line is at a logical 0 level indicating an 80386 connected processor, the AND circuit 160 is satisfied and the signal CS32 RTN is driven active indicating a 32 bit memory slave.

## Data Byte Enable

8

The local bus byte enable (BE) signals, which are driven by the local bus control logic 35 during Micro Channel master cycles, must be modified when a 32 bit Micro Channel bus master is accessing the 16 bit processor memory in an 80386SX system. If two Micro Channel byte enables are selected one from the lower 16 bits and one from the upper 16 bits of the channel data bus (-SBE0 and -SBE2), then only the byte enable active for the lower word is passed to the local bus. In this case the local bus byte enables for the upper word (-BE2 or -BE3) are forced inactive. This prevents the memory control 59 from enabling two bytes that would contend on the same data lines of the 16 bit local data bus. The Micro Channel bus master is controlled to run another cycle for the high word by means of CS32 RTN which is forced inactive for the 80386SX system as described above.

The local bus byte enables -BE0-3 are used to signal the presence of an 80386 or 80386SX processor to the bus control logic 35. Following a system power on reset or a software reset, the bus control logic senses the state of signals -BE0 to -BE3. The 80386 drives all four byte enables low during a chip reset. Since the 80386SX does not drive -BE0-3 then the signals will be left unconnected from the CPU and will float at a positive voltage during the processor reset.

## Modified Address Bus Decodes - ROM Decode

The memory map for the IBM 8570 system places a 128 KB system ROM starting at 2 different physical addresses, FFFE0000 and 000E0000. The ROM is placed at the first address which is the top of memory so that the processor executes instructions from ROM following a system reset. At the second address, POST and BIOS functions contained in the ROM code are executed. During normal system operation, the second address space is also where ROM is copied into system RAM 38 to improve system performance.

A Programmable Array Logic Device (PAL) is used to decode the processor addresses A17-31 as shown in Figure 11 to produce the ROM module chip select. This PAL decodes the high order 15 bits A17-31 of the system address bus sufficient to distinguish between 128 KB blocks for an 80386 32 bit address bus. The 80386SX processor has a 24 bit bus however and the high order 8 bits A24-31 are always zeros for its address map. Since A24 to A31 are pulled on the planar, the ROM 64 will reside at address range from FFFE0000 to FFFFFFFF. Consequently the PAL 166 must have an input in addition to the address lines to indicate whether an 80386 or an 80386SX is driving the local address bus. This unique input which is critical to accommodating the two processor types is the -SENSE signal. This signal is used in the ROM PAL equations set forth below to specify whether the line ROMSEL chip select output is activated for the 80386 or for the 80386SX. The ROM PAL equations which are unique design requirements are as follows:

```
ROMSEL    =    A31 & A30 & A29 & A28 & A27 & A26 & A25 & A24

               & A23 & A22 & A21 & A20 & A19 & A17 & A18  &

               MIO & -HLDA

          +    -A31 & -A30 & -A29 & -A28 & -A27 & -A26 & -A25

               & -A24 & -A23 & -A22 & -A21 & -A20 & A19 & A17

               & A18 & MIO & -HLDA & -ROMEN & SENSE

          +    -A23 & -A22 & -A21 & -A20 & A19 & A17 & A18 &

               MIO & -HLDA & -ROMEN & -SENSE
```

In the above equations, the first term for ROMSEL addresses the top end of four gigabytes or 16 megabytes for either the 80386 or the 80386SX because A24-A31 are pulled positive for the 80386SX and the SENSE is not required. The second term provides 80386 address at the top of 1 megabyte. The third term addresses the top of 1 megabyte for the 80386SX.

The -ROMSEL signal is applied to the memory controls 59 to select the appropriate chip select line to access the ROM 64. The low order address A0-16 are used to select the desired word in the ROM 64.

## High Order Address Enable

The IBM Micro Channel bus specification defines a signal -AEN (Figure 12) which when low indicates to a slave device that all 32 bits of the system address bus are significant and when high indicates that the bus master is only a 24 address bit device. This signal must be activated during the start of a bus cycle to specify to a slave device whether address decode is to include 32 or 24 bits. For the 80386 processor which drives 32 bits of address, the logic is designed to activate -AEN (Drive low) if any of the high order 8 bits A24-A31 are active high indicating that an address above 16 Megabytes is being driven onto the bus 34A. Since the 80386SX processor does not drive address bits 24-31 they float to an active high voltage state during processor bus cycles due to pullup resistors on the address bus. An additional logic function is required to deactivate -AEN (Float High) regardless of the state of address lines A24-A31 when an 80386SX is installed. The signal -SENSE is used to accomplish this by disabling the driver for -AEN when active low.

Thus as shown in Figure 12 the address lines A24-A31 are coupled to the output -AEN by way of NOR circuits 180-186 the outputs of which are connected to AND gate 188, the output of which is connected to the tri-state buffer 174. The SENSE line and the Hold Acknowledge Line HLDA are applied to the tri-state buffer by way of the NOR circuit 176. An active low signal on either SENSE or HLDA will be applied in inverted form to the tri-state buffer to deactivate -AEN.

Figure 13 illustrates in detail the data routing or steering control for the system of the preferred embodiment. The leftmost column indicates the type of master, 16 or 32 bit, which has control of the local bus 34 and the Micro Channel bus 54 during a data transfer operation and the upper row shows the slave and data port size.

When the master, which can be the processor 32, DMA 48, or one of the Micro Channel devices 55, is a 32 bit device and it is transferring 4 bytes of data with a slave the operation will require one, two or four cycles depending upon whether the slave device is a 32 bit, a 16 bit or an 8 bit device as illustrated by the address bits (-BE0-3 or -SBHE, A0, A1) used and the data bytes (A, B, C, D) transferred. The terms D0-D3 refer to the four groups of data bus lines D0-7, D8-15, D16-23, D24-31. Similar details for data transfer sizes of three, two and one bytes of data are shown for a 32 bit master.

When the master is a 16 bit device, only two bytes may be transferred per cycle even though it may be desired to transfer four bytes of data. Thus two cycles are required for 32 bit and 16 bit slaves when the data transfer size is 2 bytes. Two and four cycles are required for an 8 bit slave for data transfer sizes of two and four bytes. For example if bytes C, D (Figure 13) are being transferred from main memory 38 to an 8 bit device 55, the device must receive both bytes from bus 50 (0-7) to which it is connected. A 4 byte double word is transferred from memory 38 to buffers 61-1 to 61-4. The output MEM EN2, gates bytes C, D to buses D16-23, D24-31 for storage in buffer 51. Gate 124 transfers byte C from the buffer 51 to the device during the first cycle. During a second cycle, gate 126 transfers byte D from D24-31 to 5D8-15, then gate 122 transfers byte D to the device 55 via 5D0-7.

**Claims**

1. Data processing apparatus comprising

   a system planar board (20) having connectors adapted to receive system components and having a bus structure (34, 52, 120) for interconnecting said components for the performance of data processing functions under program control characterised in that there is provided

   a socket (106) on the board (20) adapted to receive a processor which may be of a first or a second type, the two types having dissimilar processor buses,

   program controlled logic on the board (20) effective when a processor of the first type is mounted in the socket for effecting data processing functions with system components connected to the bus structure and,

   additional logic on the board (20) for modifying the operation of the program controlled logic when a second processor of the second type is mounted in the socket.

2. Data processing apparatus according to claim 1 wherein the system board has a local bus, a system bus, and interface means coupling the buses to each other,

   a main memory being mounted on said board and coupled to the local bus and the

   program controlled logic means is effective when a processor is mounted in said socket to transfer

data between said system bus, the processor and main memory by way of said local bus.

3. Data processing apparatus according to claim 2 wherein

said local bus and said system bus include a local data bus and a system data bus, each having N data lines coupled to each other via said interface means;

and an adapter physically connecting upper and lower halves of the N data lines of the local data bus to each other and adapted to connect to N/2 data lines of a processor of the second type when the processor is plugged into the socket by means of the adapter.

4. The data processing apparatus according to claim 1, 2 or 3 wherein said program controlled logic means include a plurality of input/output control logic means, each adapted for connection to respective input/output devices and for the transfer of data between said input/output devices and said system bus.

5. The data processing apparatus according to claim 4 wherein input/output devices are coupled to respective ones of said input/output control logic means.

6. A data processing system in which a system planar board has a socket adapted to receive a first central processing unit having a processor bus of a first type, connectors adapted to receive system components and a board bus structure appropriate to the processor bus of the first type for interconnecting the processor bus with the system components to enable the execution of processing functions under program control, a processor mounting structure for coupling a second processor, having a bus structure of a second type differing from that of the first, to the board bus structure and system components for the execution of processing functions under program control, said processor mounting structure comprising

an adapter having a pluggable structure received in said socket,

electrical bus modification structure in the adapter for modifying the board bus structure to cooperate with a processor bus structure of the second type.

FIG 1

FIG. 2

FIG. 3

FIG. 4 A

FIG. 4 B

FIG. 5 A

FIG. 5 B

FIG. 5C

15

FIG. 5 D

FIG. 6

Vcc ———————————— Vcc

AO ——————————— AO ⎫
A1 ——————————— A1 ⎬ PINS
−BHE —————————— −BHE ⎪ ADDED
⏚ ——————————— −SENSE ⎭ FOR
GND 80386SX

D(0:15) ——16—⁄——•—16—⁄—— D(0:15)
                      16
                   ——⁄—— D(16:31)
A(2:23) ——————22—⁄—— A(2:23)
                      8
N.C.——————⁄—— A(24:31)
                      4
N.C.——————⁄—— −BE(0:3)

N.C.——————————— −BS16

INTEL 80386SX

100 PINS FLAT PACK

−ADS ————————————— −ADS
W/−R ————————————— W/−R
D/−C ————————————— D/−C
M/−IO ———————————— M/−IO
−LOCK ——————————— −LOCK
HOLD ————————————— HOLD
HLDA ————————————— HLDA
−ERROR —————————— −ERROR
−BUSY ——————————— −BUSY
PEREQ ——————————— PEREQ
INTR ————————————— INTR
NMI —————————————— NMI
−READY —————————— −READY
−NA —————————————— −NA
CLK2 ————————————— CLK2
RESET ——————————— RESET
GND —————————————— GND

⌇102                        ↑ SOCKET 106
                              OUTPUTS

160 PINS  PIN GRID ARRAY ADAPTER

⌇104                   ↑ MODIFICATIONS
                         MADE FOR 80386 SX

N.C.= NO CONNECT

FIG. 7

FIG. 8

FIG. 9

- CS 32_ REQ SLOT 2

- CS 32_ REQ SLOT 3

- DCD_ F8_ FC
( COPROCESSOR )

AND

160

162

CS 32 RTN TO
BUS CTRL &
MICRO CHANNEL

- SYS _RAM

SENSE

OR

164

SENSE = `1´  80386 SX
SENSE = `0´  80386

## FIG.10

A 17 – 31

ROMPAL
20L8B

– ROMSEL

MEMORY
CNTL

– ROM_CS

HLDA

ROMEN

MIO

– SENSE

– OE

– CE

EPROM
128K x 8

DO – 7

AO – 16

## FIG 11

FIG. 12

| | DATA TRANS SIZE | \-BE3 | \-BE2 | \-BE1 | \-BE0 | D3 | D2 | D1 | D0 | \-SBHE | A1 | A0 | D3 | D2 | D1 | D0 | \-SBHE | A1 | A0 | D3 | D2 | D1 | D0 |
|---|---|---|---|---|---|---|---|---|---|---|---|---|---|---|---|---|---|---|---|---|---|---|---|
| | | S32/32-BIT DATA PORT −CD DS 32 ACTIVE −CD DS 16 ACTIVE | | | | | | | | S16/16-BIT DATA PORT −CD DS 32 INACTIVE −CD DS 16 ACTIVE | | | | | | | S8/8-BIT DATA PORT −CD DS 32 INACTIVE −CD DS 16 INACTIVE | | | | | | |
| M32 | 4 BYTE | 0 | 0 | 0 | 0 | D | C | B | A | 0 | 0 | 0 | − | − | B | A | − | 0 | 0 | − | − | − | A |
| | | | | | | | | | | 0 | 1 | 0 | − | − | D | C | − | 0 | 1 | − | − | − | B |
| TR | | | | | | | | | | | | | | | | | − | 1 | 0 | − | − | − | C |
| 32 | | | | | | | | | | | | | | | | | − | 1 | 1 | − | − | − | D |
| =0 | 3 BYTE | 1 | 0 | 0 | 0 | − | C | B | A | 0 | 0 | 0 | − | − | B | A | − | 0 | 0 | − | − | − | A |
| | | | | | | | | | | 1 | 1 | 0 | − | − | − | C | − | 0 | 1 | − | − | − | B |
| | | | | | | | | | | | | | | | | | − | 1 | 0 | − | − | − | C |
| | | 0 | 0 | 0 | 1 | D | C | B | − | 0 | 0 | 1 | − | − | B | − | − | 0 | 1 | − | − | − | B |
| | | | | | | | | | | 0 | 1 | 0 | − | − | D | C | − | 1 | 0 | − | − | − | C |
| | | | | | | | | | | | | | | | | | − | 1 | 1 | − | − | − | D |
| | 2 BYTE | 1 | 1 | 0 | 0 | − | − | B | A | 0 | 0 | 0 | − | − | B | A | − | 0 | 0 | − | − | − | A |
| | | | | | | | | | | | | | | | | | − | 0 | 1 | − | − | − | B |
| | | 1 | 0 | 0 | 1 | − | C | B | − | 0 | 0 | 1 | − | − | B | − | − | 0 | 1 | − | − | − | B |
| | | | | | | | | | | 1 | 1 | 0 | − | − | − | C | − | 1 | 0 | − | − | − | C |
| | | 0 | 0 | 1 | 1 | D | C | − | − | 0 | 1 | 0 | − | − | D | C | − | 1 | 0 | − | − | − | C |
| | | | | | | | | | | | | | | | | | − | 1 | 1 | − | − | − | D |
| | 1 BYTE | 1 | 1 | 1 | 0 | − | − | − | A | 1 | 0 | 0 | − | − | − | A | − | 0 | 0 | − | − | − | A |
| | | 1 | 1 | 0 | 1 | − | − | B | − | 0 | 0 | 1 | − | − | B | − | − | 0 | 1 | − | − | − | B |
| | | 1 | 0 | 1 | 1 | − | C | − | − | 1 | 1 | 0 | − | − | − | C | − | 1 | 0 | − | − | − | C |
| | | 0 | 1 | 1 | 1 | D | − | − | − | 0 | 1 | 1 | − | − | D | − | − | 1 | 1 | − | − | − | D |
| M16 | 2 BYTE | 1 | 1 | 0 | 0 | − | − | B | A | 0 | 0 | 0 | − | − | B | A | − | 0 | 0 | − | − | − | A |
| | | | | | | | | | | | | | | | | | − | 0 | 1 | − | − | − | B |
| TR | | 0 | 0 | 1 | 1 | D | C | − | − | 0 | 1 | 0 | − | − | D | C | − | 1 | 0 | − | − | − | C |
| 32 | | | | | | | | | | | | | | | | | − | 1 | 1 | − | − | − | D |
| =1 | 1 BYTE | 1 | 1 | 1 | 0 | − | − | − | A | 1 | 0 | 0 | − | − | − | A | − | 0 | 0 | − | − | − | A |
| | | 1 | 1 | 0 | 1 | − | − | B | − | 0 | 0 | 1 | − | − | B | − | − | 0 | 1 | − | − | − | B |
| | | 1 | 0 | 1 | 1 | − | C | − | − | 1 | 1 | 0 | − | − | | C | − | 1 | 0 | − | − | − | C |
| | | 0 | 1 | 1 | 1 | D | − | − | − | 0 | 1 | 1 | − | − | D | − | − | 1 | 1 | − | − | − | D |

-Key-

| | | | |
|---|---|---|---|
| A,B,C,D | − Byte Transferred | S32 − 32-bit Slave | D0 − D(0-7) |
| − | − Not Used by the Slave | S16 − 16-bit Slave | D1 − D(8-15) |
| M32 | − 32-bit Master | S8 − 8-bit Slave | D2 − D(16-23) |
| M16 | − 16-bit Master | | D3 − D(24-31) |

# FIG. 13

European
Patent Office

**EUROPEAN SEARCH
REPORT**

Application Number

**EP 91 30 5846**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | IBM TECHNICAL DISCLOSURE BULLETIN. vol. 33, no. 3B, August 1990, NEW YORK US pages 112 - 113; '32-BIT MEMORY SUBSYSTEM SUPPORTS INTEL 80386 AND 80386SX PROCESSORS' | 1-5 | G 06 F 13/40 |
| X | | 6 | |
| | – – – | | |
| Y | IBM TECHNICAL DISCLOSURE BULLETIN. vol. 33, no. 2, July 1990, NEW YORK US pages 38 - 39; 'METHOD FOR USING A THIRTY-TWO BIT SLAVE IN A SIXTEEN-BIT MICRO CHANNEL ARCHITECTURE SYSTEM' * the whole document * * | 1-5 | |
| | – – – | | |
| A | EP-A-0 343 770 (INTERNATIONAL BUSINESS MACHINES CORPORATION) * page 4, line 2 - line 21; figure 2 * * | 1,6 | |
| | – – – – – | | |

|  |
|---|
| TECHNICAL FIELDS SEARCHED (Int. Cl.5) |
| G 06 F |

The present search report has been drawn up for all claims

| Place of search | Date of completion of search | Examiner |
|---|---|---|
| The Hague | 24 October 91 | WANZEELE R.J. |